# EUROPEAN PATENT APPLICATION

(11) **EP 4 764 772 A1**
(43) Date of publication of application: **24.06.2026**
(21) Application number: 24882948.3
(22) Date of filing: 10.10.2024
(51) Int. Cl.: G06F 1/16, H05K 5/03

(54) **FLEXIBLE DISPLAY AND ELECTRONIC DEVICE COMPRISING SAME**

(30) Priority: 27.10.2023 KR 20230145719; 20.11.2023 KR 20230160017
(71) Applicant: Samsung Electronics Co., Ltd., Suwon-si, Gyeonggi-do 16677 (KR)
(72) Inventor: HONG, Dongsool, Suwon-si, Gyeonggi-do 16677 (KR); JI, Junmin, Suwon-si, Gyeonggi-do 16677 (KR)
(74) Representative: Gulde & Partner
(86) International application number: PCT/KR2024/096288
(87) International publication number: WO 2025/089922

(57) **Abstract**

According to one embodiment of the present disclosure, an electronic device may comprise a housing, a flexible display, a support plate or a cover member. The housing can include a first housing or a second housing. The second housing can be disposed to be rotatable with respect to the first housing. The flexible display can be disposed on the housing. The support plate can be disposed between the housing and the flexible display. The support plate can be formed to support the flexible display. The cover member can cover at least a portion of the edge of the flexible display. The cover member can be coupled to the support plate.

## Description

### [Technical Field]

Various embodiments of the disclosure relate to an electronic device, for example, a flexible display and an electronic device including the same.

### [Background Art]

With the remarkable advancement of information and communication technology and semiconductor technology, the distribution and use of various electronic devices are rapidly increasing. In particular, recent electronic devices are being developed to be portable and capable of communication.

An electronic device may refer to a device that performs a specific function according to a mounted program, such as home appliances, electronic organizers, portable multimedia players, mobile communication terminals, tablet PCs, video/audio devices, desktop/laptop computers, or vehicle navigation systems. For example, such electronic devices may output stored information as sound or video. As the integration density of electronic devices increases and ultra-high-speed, high-capacity wireless communication becomes common, recently, various functions may be mounted on a single electronic device such as a mobile communication terminal. For example, not only a communication function but also an entertainment function such as a game, a multimedia function such as music/video playback, a communication and security function for mobile banking, and a schedule management or electronic wallet function are being integrated into a single electronic device. Such electronic devices are being downsized so that a user can conveniently carry them.

As mobile communication services expand to a multimedia service area, the size of a display of an electronic device may increase in order for a user to sufficiently use not only voice calls or short messages but also multimedia services. Accordingly, a foldable flexible display may be disposed in an entire area of a housing structure separated to be foldable.

The above-described information may be provided as related art for the purpose of helping understanding of the disclosure. No claim or determination is made as to whether any of the above-described content is applicable as prior art related to the disclosure.

### [Detailed Description of the Invention]

### [Technical Solution]

According to an embodiment of the disclosure, an electronic device may include a housing, a flexible display, a support plate, or a cover member. The housing may include a first housing or a second housing. The second housing may be disposed to be rotatable with respect to the first housing. The flexible display may be disposed over the housing. The support plate may be disposed between the housing and the flexible display. The support plate may be configured to support the flexible display. The cover member may cover at least a portion of an edge of the flexible display. The cover member may be coupled to the support plate.

According to an embodiment of the disclosure, an electronic device may include a housing, a flexible display, a support plate, or a cover member. The housing may include a first housing or a second housing. The second housing may be disposed to be rotatable with respect to the first housing. The flexible display may be disposed over the housing. The support plate may be disposed between the housing and the flexible display. The support plate may be configured to support the flexible display. The support plate may include a lattice pattern. The lattice pattern may include a plurality of openings. The cover member may cover at least a portion of an edge of the flexible display. The cover member may be located corresponding to the lattice pattern.

### [Brief Description of Drawings]

FIG. 1 is a block diagram illustrating an electronic device in a network environment according to an embodiment.
FIG. 2 is a view illustrating an unfolded state of an electronic device according to an embodiment of the disclosure.
FIG. 3 is a view illustrating a folded state of an electronic device according to an embodiment of the disclosure.
FIG. 4 is an exploded perspective view illustrating an electronic device according to an embodiment of the disclosure.
FIG. 5 is an exploded perspective view illustrating a flexible display, a protective member, and a cover member according to an embodiment of the disclosure.
FIG. 6 is a coupled perspective view illustrating a flexible display, a protective member, and a cover member according to an embodiment of the disclosure.
FIG. 7 is a coupled perspective view illustrating a flexible display, a support plate, and a cover member according to an embodiment of the disclosure.
FIG. 8 is a plan view illustrating a state in which an edge of a flexible display is covered by a cover member according to an embodiment of the disclosure.
FIG. 9 is a plan view illustrating a state in which an edge of a flexible display is covered by a cover member according to an embodiment of the disclosure, viewed from a direction opposite to FIG. 8.
FIG. 10 is a perspective view illustrating a state in which an edge of a flexible display is covered by a cover member according to an embodiment of the disclosure.
FIG. 11 is a side view illustrating a state in which an edge of a flexible display is covered by a cover member according to an embodiment of the disclosure.
FIG. 12 is a plan view illustrating a support plate according to an embodiment of the disclosure.
FIG. 13 is a perspective view illustrating a cover member according to an embodiment of the disclosure.
FIG. 14 is a perspective view illustrating a cover member according to an embodiment of the disclosure, viewed from a direction different from FIG. 13.
FIG. 15 is a side view illustrating a state in which a flexible display and a cover member are folded according to an embodiment of the disclosure.
FIG. 16 is a cross-sectional view taken along line B-B' of FIG. 8 according to an embodiment of the disclosure.
FIG. 17 is a cross-sectional view taken along line B-B' of FIG. 8 according to an embodiment of the disclosure.
FIG. 18 is a plan view illustrating a support plate and a coupling portion according to an embodiment of the disclosure.
FIG. 19 is a perspective view illustrating an electronic device including a flexible display and a blocking assembly according to an embodiment of the disclosure.
FIG. 20 is an exploded perspective view illustrating a support plate and a blocking assembly according to an embodiment of the disclosure.
FIG. 21 is an exploded perspective view illustrating a support plate and a blocking assembly according to an embodiment of the disclosure, viewed from a direction different from FIG. 20.

### [Mode for Carrying out the Invention]

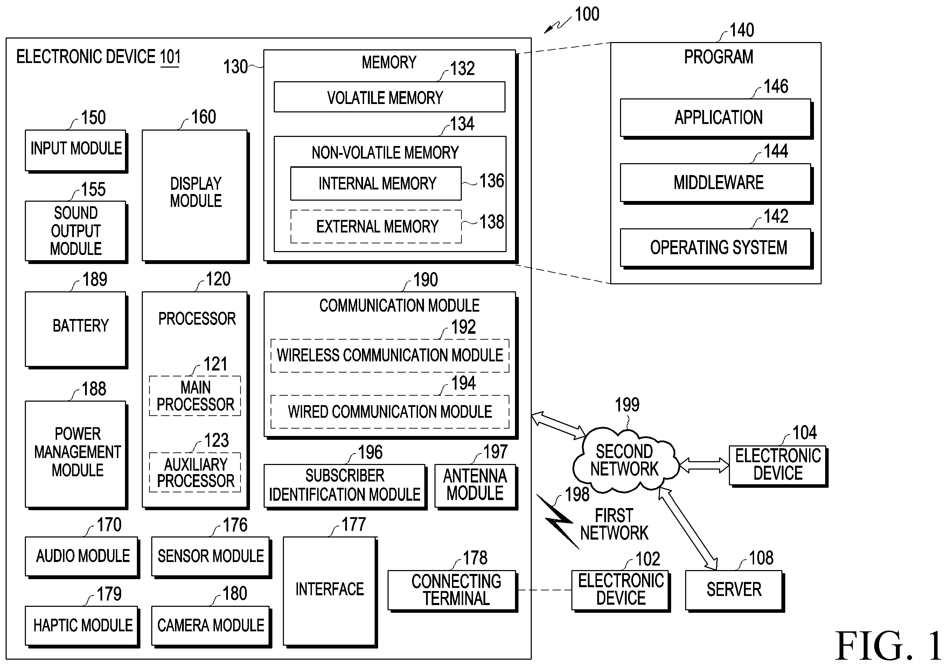

FIG. 1 is a block diagram illustrating an electronic device 101 in a network environment 100, according to various embodiments.

Referring to FIG. 1, the electronic device 101 in the network environment 100 may communicate with at least one of an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., the program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operation state (e.g., power or temperature) of the electronic device 101 or an external environmental state (e.g., the user's state), and then generate an electrical signal or data value corresponding to the detected state. According to an embodiment, the sensor module 176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wiredly) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wiredly) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, instructions or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The storage medium readable by the machine may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

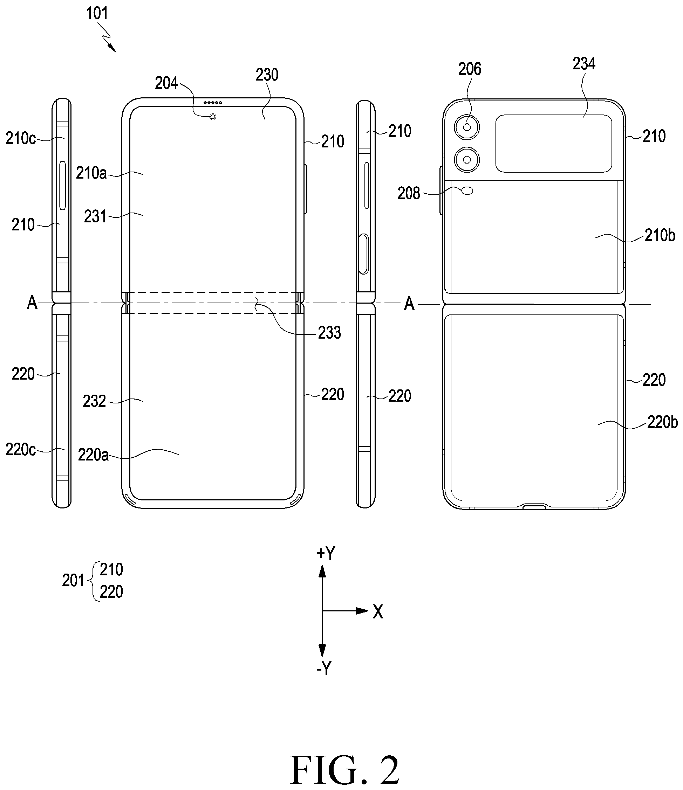

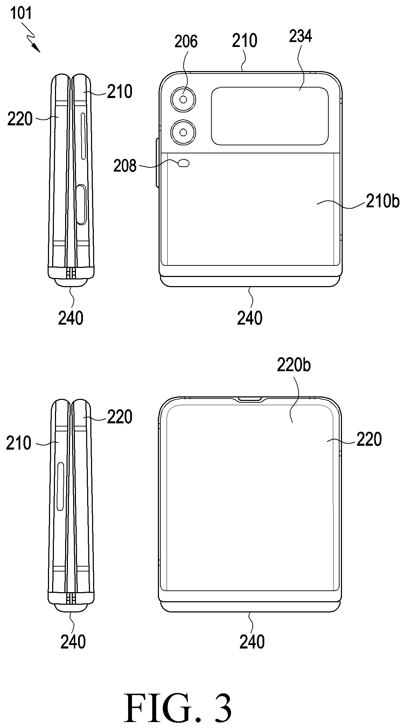

FIG. 2 is a view illustrating an unfolded state of an electronic device according to an embodiment of the disclosure. FIG. 3 is a view illustrating a folded state of an electronic device according to an embodiment of the disclosure.

The configuration of the electronic device 101 of FIGS. 2 and 3 may be identical in whole or part to the configuration of the electronic device 101 of FIG. 1.

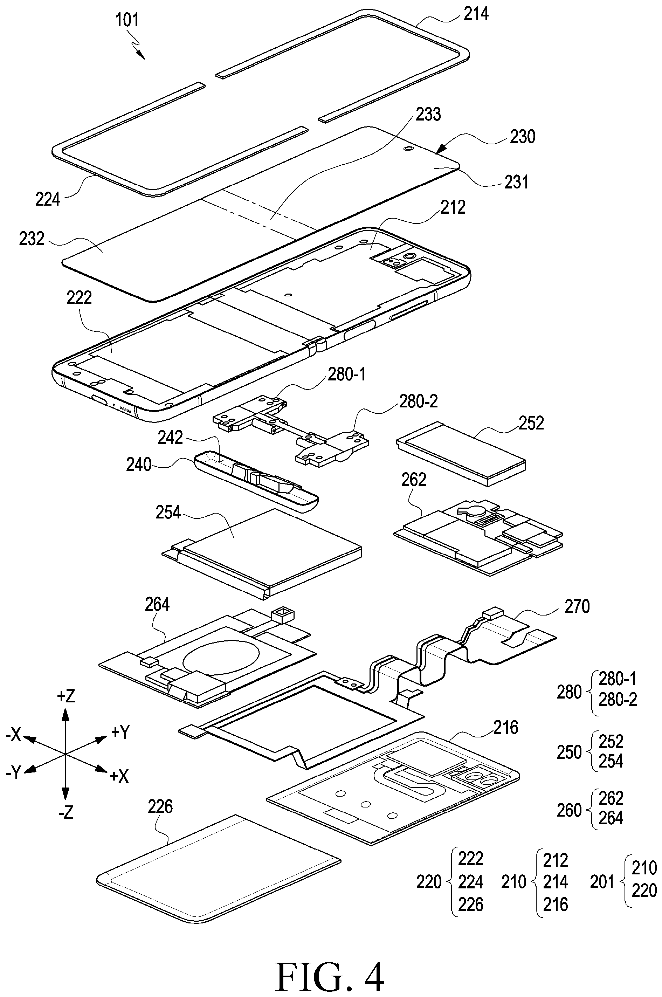

The embodiments of FIGS. 2 and 3 may be combined with the embodiment of FIG. 1 or the embodiments of FIGS. 4 to 21.

Referring to FIGS. 2 and 3, an electronic device 101 may include a housing 201 for receiving a component (e.g., the hinge structure 280 of FIG. 4) of the electronic device 101 and a flexible display or foldable display 230 disposed in the space formed by the housing 201. According to an embodiment, the housing 201 may be referred to as a foldable housing. According to an embodiment, the flexible display 230 may be referred to as a foldable display.

According to an embodiment, the housing 201 may include a first housing 210 and a second housing 220 configured to rotate about the first housing 210.

According to an embodiment, the first housing 210 and/or the second housing 220 may form a portion of the exterior of the electronic device 101. According to an embodiment, the surface where the display 230 is visually exposed is defined as a front surface (e.g., a first front surface 210a and a second front surface 220a) of the electronic device 101 and/or housing 201. A surface opposite to the front surface is defined as a rear surface (e.g., the first rear surface 210b and the second rear surface 220b) of the electronic device 101. A surface surrounding at least a portion of the space between the front surface and the rear surface is defined as a side surface (e.g., the first side surface 210c and the second side surface 220c) of the electronic device 101.

According to an embodiment, the first housing 210 may be rotatably connected to the second housing 220 by a hinge structure (e.g., the hinge structure 280 of FIG. 4). For example, the first housing 210 and the second housing 220 may be connected to each other to be rotatable about the hinge structure 280. Thus, the electronic device 101 may turn into a folded state (e.g., FIG. 3) or unfolded state (e.g., FIG. 2). In the folded state of the electronic device 101, the first front surface 210a may face the second front surface 220a and, in the unfolded state, the direction in which the first front surface 210a faces may be substantially the same as the direction in which the second front surface 220a faces. For example, in the unfolded state, the first front surface 210a may be positioned on substantially the same plane as the second front surface 220a. According to an embodiment, the second housing 220 may provide a motion relative to the first housing 210.

According to an embodiment, the first housing 210 and the second housing 220 are disposed on both sides of the folding axis A and be overall symmetrical in shape with respect to the folding axis A. The angle between the first housing 210 and the second housing 220 may be changed depending on whether the electronic device 101 is in the unfolded state, the folded state, or an intermediate state between the unfolded state and the folded state.

According to an embodiment, the electronic device 101 may include a hinge cover 240. At least a portion of the hinge cover 240 may be disposed between the first housing 210 and the second housing 220. According to an embodiment, the hinge cover 240 may be hidden by a portion of the first housing 210 and second housing 220 or be exposed to the outside depending on the state of the electronic device 101. According to an embodiment, the hinge cover 240 may protect the hinge structure (e.g., the hinge structure 280 of FIG. 4) from an external impact of the electronic device 101. According to an embodiment, the hinge cover 240 may be interpreted as a hinge housing for protecting the hinge structure (e.g., the hinge structure 280 of FIG. 4).

According to an embodiment, as shown in FIG. 2, in the unfolded state of the electronic device 101, the hinge cover 240 may be hidden, and thus not exposed, by the first housing 210 and the second housing 220. According to an embodiment, as shown in FIG. 3, in the folded state (e.g., a fully folded state) of the electronic device 101, the hinge cover 240 may be exposed to the outside between the first housing 210 and the second housing 220. According to an embodiment, in an intermediate state in which the first housing 210 and the second housing 220 are folded with a certain angle, the hinge cover 240 may be partially exposed to the outside between the first housing 210 and the second housing 220. However, in this case, the exposed area may be smaller than that in the completely folded state. In an embodiment, the hinge cover 240 may include a curved surface.

According to an embodiment, the flexible display 230 may visually provide information to the outside (e.g., the user) of the electronic device 101. The flexible display 230 may include, e.g., a hologram device or a projector and a control circuit for controlling the corresponding device. According to an embodiment, the flexible display 230 may include a touch sensor configured to sense a touch or a pressure sensor configured to measure an intensity of a force generated by the touch.

According to an embodiment, the flexible display 230 may refer to a display in which at least a partial area thereof may be deformed into a flat surface or a curved surface. For example, the flexible display 230 may be formed to be variable in response to relative movement of the second housing 220 with respect to the first housing 210. According to an embodiment, the flexible display 230 may include a folding area 233, a first display area 231 disposed on one side (e.g., above (+Y direction)) with respect to the folding area 233, and a second display area 232 disposed on the other side (e.g., below (-Y direction)). According to an embodiment, the folding area 233 may be formed over the hinge structure (e.g., the hinge structure 280 of FIG. 4). For example, at least a portion of the folding area 233 may face the hinge structure 280. According to an embodiment, the first display area 231 may be disposed on the first housing 210, and the second display area 232 may be disposed on the second housing 220. According to an embodiment, the flexible display 230 may be received in the first housing 210 and the second housing 220.

However, the segmentation of the flexible display 230 as shown in FIG. 2 is merely an example, and the flexible display 230 may be divided into a plurality of (e.g., four or more, or two) areas depending on the structure or function thereof.

Further, in the embodiment illustrated in FIG. 2, an area of the flexible display 230 may be divided by the folding area 233 or the folding axis (A-axis) extending parallel to the X-axis. According to an embodiment, an area of the flexible display 230 may be divided based on another folding area (e.g., a folding area parallel to the Y-axis) or another folding axis (e.g., a folding axis parallel to the Y-axis). According to an embodiment, the flexible display 230 may be combined with or disposed adjacent to a touch sensing circuit, a pressure sensor capable of measuring a touch intensity (pressure), and/or a digitizer configured to detect a magnetic field type stylus pen.

According to an embodiment, the electronic device 101 may include a rear display 234. The rear display 234 may be disposed to face a direction different from the flexible display 230. For example, the flexible display 230 may be visually exposed through a front surface of the electronic device 101 (e.g., the first front surface 210a and/or the second front surface 220a), and the rear display 234 may be visually exposed through a rear surface of the electronic device 101 (e.g., the first rear surface 210b).

According to an embodiment, the electronic device 101 may include at least one camera module 204, 206 and a flash 208. According to an embodiment, the electronic device 101 may include a front camera module 204 exposed through the front surface (e.g., the first front surface 210a) and/or a rear camera module 206 exposed through the rear surface (e.g., the first rear surface 210b). The camera modules 204, 206 may include one or more lenses, an image sensor, a flash, and/or an image signal processor. The flash 208 may include a light emitting diode (LED) or a xenon lamp. According to an embodiment, two or more lenses (an infrared (IR) camera, a wide-angle lens, and a telescopic lens) and image sensors may be disposed on one surface of the electronic device 101. The configuration of the front camera module 204 and/or rear camera module 206 may be identical in whole or part to the configuration of the camera module 180 of FIG. 1.

FIG. 4 is an exploded perspective view illustrating an electronic device according to an embodiment of the disclosure.

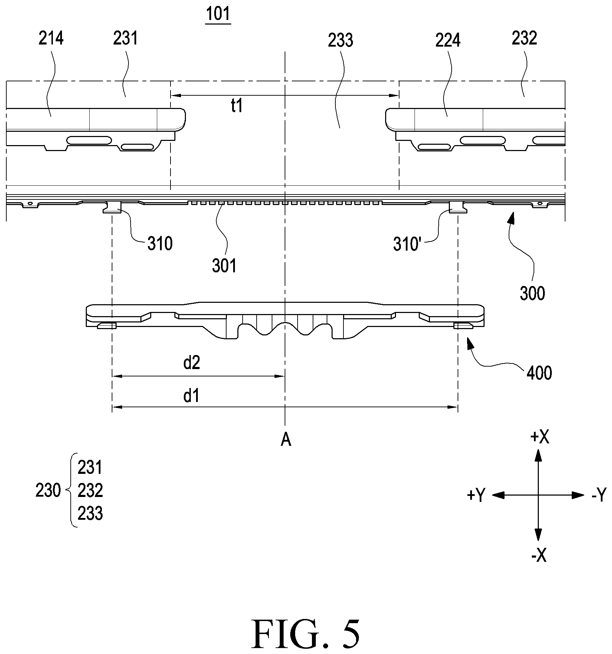

The embodiment of FIG. 4 may be combined with the embodiments of FIGS. 1 to 3 or the embodiments of FIGS. 5 to 21.

Referring to FIG. 4, the electronic device 101 (e.g., the electronic device 101 of FIG. 1 or the electronic device 101 of FIGS. 2 to 3) may include a housing 201, a first housing 210, a second housing 220, a flexible display 230, a hinge cover 240, a battery 250, a printed circuit board 260, a flexible circuit board 270, and a hinge structure 280. The configuration of the housing 201, the first housing 210, the second housing 220, the flexible display 230, and the hinge cover 240 of FIG. 4 may be identical in whole or part to the configuration of the housing 201, the first housing 210, the second housing 220, the flexible display 230, and the hinge cover 240 of FIG. 2 and/or FIG. 3.

According to an embodiment, the electronic device 101 may include a first supporting member 212 or a second supporting member 222. For example, the first housing 210 may include a first supporting member 212, and the second housing 220 may include a second supporting member 222. According to an embodiment, the first supporting member 212 and/or the second supporting member 222 may support components of the electronic device 101 (e.g., the flexible display 230, the battery 250, and the printed circuit board 260).

According to an embodiment, the first supporting member 212 and/or the second supporting member 222 may be formed of a metal material and/or a non-metal (e.g., polymer) material. According to an embodiment, the first supporting member 212 may be disposed between the flexible display 230 and the battery 250. For example, the flexible display 230 may be coupled to one surface of the first supporting member 212, and the battery 250 and the printed circuit board 260 may be disposed on the other surface.

According to an embodiment, the electronic device 101 may include a first protective member 214 or a second protective member 224. For example, the first housing 210 may include a first protective member 214, and the second housing 220 may include a second protective member 224. According to an embodiment, the protective member 214 or 224 may protect the flexible display 230 from an external impact. For example, the first protective member 214 may surround at least a portion of a portion (e.g., the first display area 231 of FIG. 2) of the display 230, and the second protective member 224 may surround at least a portion of another portion (e.g., the second display area 232 of FIG. 2) of the display 230.

According to an embodiment, the first protective member 214 may cover an edge of the first display area 231. For example, the first protective member 214 may cover three edges of the first display area 231. The first protective member 214 may be coupled to the first supporting member 212.

According to an embodiment, the second protective member 224 may cover an edge of the second display area 232. For example, the second protective member 224 may cover three edges of the second display area 232. The second protective member 224 may be coupled and/or connected to the second supporting member 222.

According to an embodiment, the housing 201 may include a first rear plate 216 and a second rear plate 226. For example, the first housing 210 may include a first rear plate 216 connected to the first supporting member 212, and the second housing 220 may include a second rear plate 226 connected to the second supporting member 222. According to an embodiment, the rear plates 216 and 226 may form at least a portion of the exterior of the electronic device 101. For example, the first rear plate 216 may form a first rear surface (e.g., the first rear surface 210b of FIGS. 2 to 3), and the second rear plate 226 may form a second rear surface (e.g., the second rear surface 220b of FIGS. 2 to 3). According to an embodiment, the first battery 252 and the first printed circuit board 262 may be disposed between the first supporting member 212 and the first rear plate 216. The second battery 254 and the second printed circuit board 264 may be disposed between the second supporting member 222 and the second rear plate 226.

According to an embodiment, the hinge cover 240 may accommodate at least a portion of the hinge structure 280. For example, the hinge cover 240 may include an accommodation recess 242 for accommodating the hinge structure 280. According to an embodiment, the hinge cover 240 may be coupled to the hinge structure 280. According to an embodiment, when the electronic device 101 is in an unfolded state, at least a portion of the hinge cover 240 may be located between the hinge structure 280 and the housing 201.

According to an embodiment, the battery 250 may be a device for supplying power to at least one component of the electronic device 101, and may include a primary cell which is not rechargeable, a secondary cell which is rechargeable, or a fuel cell. The battery 250 may be integrally disposed inside the electronic device 101 or may be disposed to be detachable from the electronic device 101. According to an embodiment, the battery 250 may include a first battery 252 disposed in the first housing 210 and a second battery 254 disposed in the second housing 220. For example, the first battery 252 may be disposed on the first supporting member 212. The second battery 254 may be disposed on the second supporting member 222.

According to an embodiment, a processor (e.g., the processor 120 of FIG. 1), memory (e.g., the memory 130 of FIG. 1), and/or an interface (e.g., the interface 177 of FIG. 1) may be mounted on the printed circuit board 260. According to an embodiment, the printed circuit board 260 may include a first printed circuit board 262 disposed in the first housing 210 and a second printed circuit board 264 disposed in the second housing 220.

According to an embodiment, a flexible circuit board 270 may electrically connect a component (e.g., the first printed circuit board 262) located in the first housing 210 and a component (e.g., the second printed circuit board 264) located in the second housing 220. According to an embodiment, the flexible circuit board 270 may be a flexible printed circuit board (FPCB). According to an embodiment, at least a portion of the flexible circuit board 270 may cross the hinge cover 240 and/or the hinge structure 280. For example, a portion of the flexible circuit board 270 may be disposed within the first housing 210, and another portion may be disposed within the second housing 220. According to an embodiment, the flexible circuit board 270 may be connected to an antenna or connected to the flexible display 230. According to an embodiment, the flexible circuit board 270 may be configured such that at least a portion thereof is capable of bending.

According to an embodiment, the hinge structure 280 may be connected to the first housing 210 and the second housing 220. According to an embodiment, the first housing 210 may rotate about the second housing 220 by the hinge structure 280. According to an embodiment, the hinge structure 280 may rotatably connect the first housing 210 and the second housing 220 from a folded state (e.g., FIG. 3) to an unfolded state (e.g., FIG. 2).

According to an embodiment, the hinge structure 280 may include a plurality of hinge structures 280-1 and 280-2 disposed in parallel. For example, the hinge structure 280 may include a first hinge structure 280-1 and a second hinge structure 280-2 spaced apart from the first hinge structure 280-1. According to an embodiment, the first hinge structure 280-1 may be symmetrical with the second hinge structure 280-2 with respect to the length direction (e.g., the Y-axis direction) of the electronic device 101.

FIG. 5 is an exploded perspective view illustrating a flexible display, a protective member, and a cover member according to an embodiment of the disclosure.

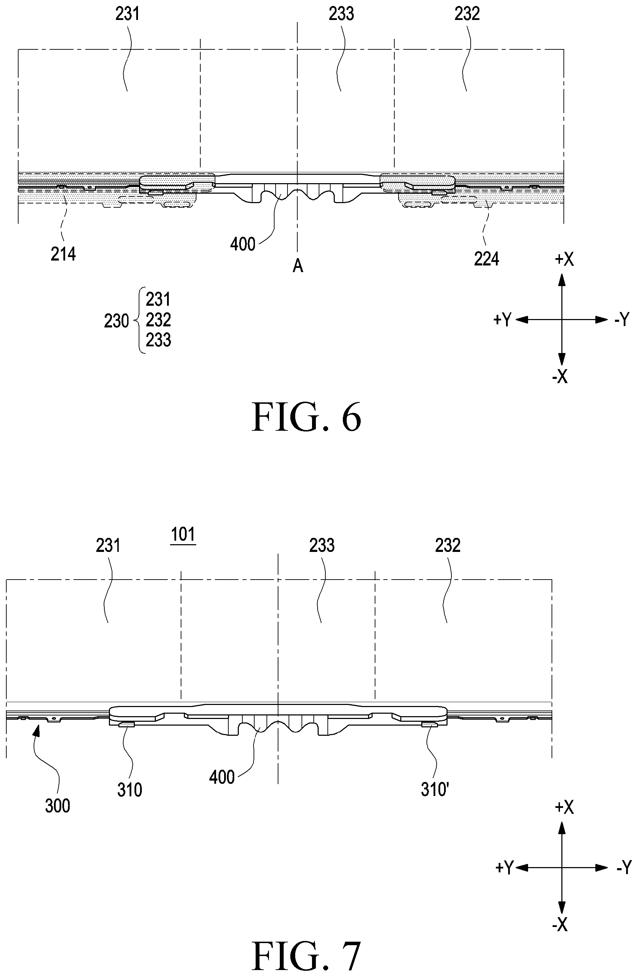

FIG. 6 is a coupled perspective view illustrating a flexible display, a protective member, and a cover member according to an embodiment of the disclosure.

FIG. 7 is a coupled perspective view illustrating a flexible display, a support plate, and a cover member according to an embodiment of the disclosure.

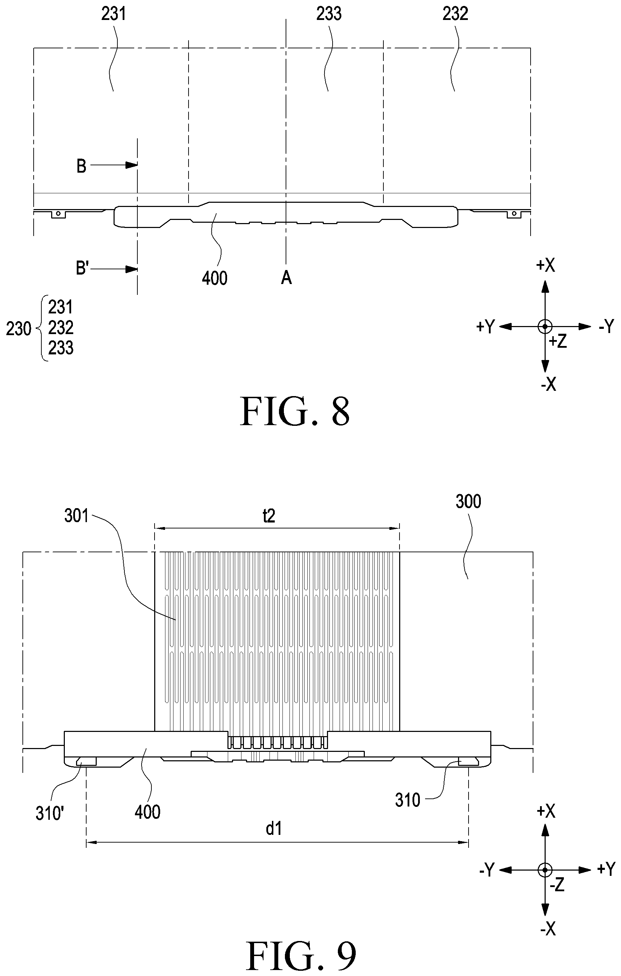

FIG. 8 is a plan view illustrating a state in which an edge of a flexible display is covered by a cover member according to an embodiment of the disclosure.

FIG. 9 is a plan view illustrating a state in which an edge of a flexible display is covered by a cover member according to an embodiment of the disclosure, viewed from a direction opposite to FIG. 8.

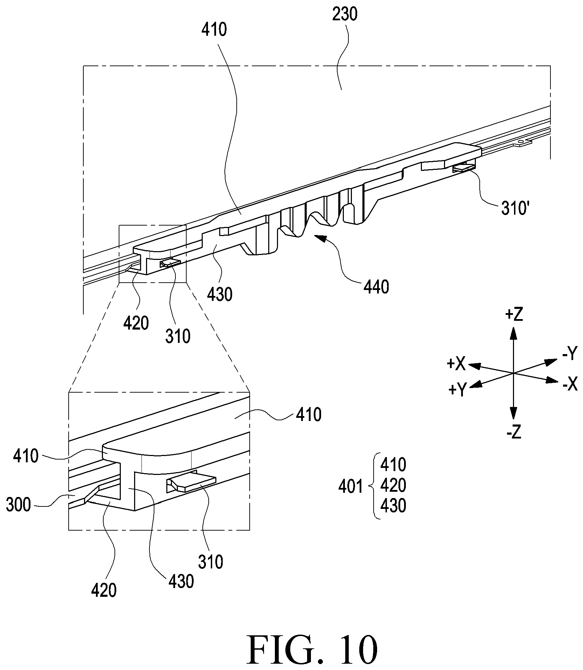

The embodiments of FIGS. 5 to 9 may be combined with the embodiments of FIGS. 1 to 4, or the embodiments of FIGS. 10 to 21.

Referring to FIGS. 5 to 9, the electronic device 101 (e.g., the electronic device 101 of FIG. 1 or the electronic device 101 of FIGS. 2 to 4) may include a first protective member 214, a second protective member 224, a flexible display 230, a support plate 300, or a cover member 400.

The configuration of the first protective member 214, the second protective member 224, or the flexible display 230 of FIGS. 5 to 10 may be identical in whole or part to the configuration of the first protective member 214, the second protective member 224, or the flexible display 230 of FIG. 4.

According to an embodiment, the flexible display 230 may be disposed over a housing (e.g., the housing 201 of FIG. 4). For example, the flexible display 230 may be disposed over a first supporting member (e.g., the first supporting member 212 of FIG. 4) and a second supporting member (e.g., the second supporting member 222 of FIG. 4).

According to an embodiment, the flexible display 230 may include a first display area 231 (e.g., the first display area 231 of FIG. 4), a second display area 232 (e.g., the second display area 232 of FIG. 4), or a folding area 233 (e.g., the folding area 233 of FIG. 4).

According to an embodiment, the support plate 300 may be disposed between the flexible display 230 and the housing. For example, the support plate 300 may be disposed between an inner surface of the flexible display 230 (e.g., a surface facing the -Z direction of FIG. 4) and the housing.

According to an embodiment, the support plate 300 may be configured to support the flexible display 230. The support plate 300 may be configured to support the inner surface or the rear surface of the flexible display 230. One surface of the support plate 300 may be coupled to the inner surface of the flexible display 230. For example, one surface of the support plate 300 may be coupled to the inner surface of the flexible display 230 through an adhesive. The adhesive may include at least one of a double-sided tape, an optical clear adhesive (OCA), a pressure sensitive adhesive (PSA), a heat-reactive adhesive, or a general adhesive, but the disclosure is not limited thereto.

According to an embodiment, the support plate 300 may include at least one of stainless steel, copper (Cu), or aluminum (Al). The support plate 300 may be configured to reinforce rigidity of the electronic device 101. The support plate 300 may be configured to shield noise and dissipate heat emitted from peripheral heat-emitting components.

According to an embodiment, the support plate 300 may have an overall plate shape or panel shape. The support plate 300 may include a plurality of openings and/or a plurality of slits formed in at least a portion of the support plate 300. The plurality of openings and/or the plurality of slits may be defined and/or referred to as a lattice pattern 301. The support plate 300 may be defined and/or referred to as a lattice plate.

According to an embodiment, the lattice pattern 301 may be formed through or recessed in at least a portion of the support plate 300. The lattice pattern 301 may be located corresponding to a hinge structure (e.g., the hinge structure 280 of FIG. 4) in the support plate 300. For example, the lattice pattern 301 may be formed in at least a portion of the support plate 300 facing the hinge structure. The lattice pattern 301 may provide flexibility to the support plate 300. The lattice pattern 301 may be disposed or located on the folding area 233.

According to an embodiment, the first protective member 214 may be disposed to cover at least a portion of the flexible display 230. For example, the first protective member 214 may cover an edge of the first display area 231. The second protective member 224 may be disposed to cover at least a portion of the flexible display 230. For example, the second protective member 224 may cover an edge of the second display area 232.

According to an embodiment, the cover member 400 may be disposed to cover at least a portion of the flexible display 230. For example, the cover member 400 may be disposed to surround at least a portion of the edge of the flexible display 230.

According to an embodiment, the cover member 400 may cover at least a portion of an edge of the folding area 233. The cover member 400 may cover at least a portion of the first display area 231 and at least a portion of the second display area 232.

According to an embodiment, at least a portion of the cover member 400 may be located between the first protective member 214 and the flexible display 230. Another portion of the cover member 400 may be located between the second protective member 224 and the flexible display 230.

According to an embodiment, the cover member 400, by covering the edge of the folding area 233, may limit and/or reduce external foreign objects from entering the edge of the folding area 233. The cover member 400 may be defined and/or referred to as a dust cover. According to an embodiment, the cover member 400 may have a shape that is symmetric on two opposite sides with respect to the folding axis A (e.g., the folding axis A of FIG. 2), but the disclosure is not limited thereto.

According to an embodiment, the cover member 400 may be coupled to the support plate 300. For example, the cover member 400 may be fixed to the support plate 300.

According to an embodiment, the support plate 300 may include a coupling portion 310 or 310'. The coupling portion 310 or 310' may protrude from an edge or a side of the support plate 300. The coupling portion 310 or 310' may include a first coupling portion 310 or a second coupling portion 310'.

According to an embodiment, the first coupling portion 310 may protrude from a portion of the support plate 300 supporting the first display area 231. The second coupling portion 310' may protrude from a portion of the support plate 300 supporting the second display area 232. According to the illustrated embodiment, the first coupling portion 310 and the second coupling portion 310' are each illustrated as one, but the disclosure is not limited thereto. For example, the first coupling portion 310 and the second coupling portion 310' may each be provided in plurality. Hereinafter, for convenience of description, the first coupling portion 310 is exemplarily described, but the description thereof may be equally applied and/or understood for the second coupling portion 310'.

According to an embodiment, the first coupling portion 310 may be coupled to the cover member 400. For example, at least a portion of the first coupling portion 310 may be configured to be inserted into at least a portion of the cover member 400. At least a portion of the first coupling portion 310 may be fixed to the cover member 400.

According to an embodiment, when a state of the electronic device 101 is an unfolded state (e.g., FIG. 2 or FIGS. 5 to 9), the first coupling portion 310 may be spaced apart from the second coupling portion 310' by a designated first distance d1 with respect to a length direction (e.g., Y-axis direction of FIGS. 5 to 9) of the electronic device 101 (hereinafter, referred to as "first direction"). For example, the first distance d1 may be greater than a width (e.g., the width t1 of FIG. 5) of the folding area 233 in the first direction (e.g., Y-axis direction of FIGS. 5 to 9). The first distance d1 may be greater than a width (e.g., the width t2 of FIG. 9) of the lattice pattern 301 in the first direction (e.g., Y-axis direction of FIGS. 5 to 9).

According to an embodiment, when a state of the electronic device 101 is an unfolded state (e.g., FIG. 2 or FIGS. 5 to 9), the folding area 233 and/or the lattice pattern 301 may be located between the first coupling portion 310 and the second coupling portion 310'.

According to an embodiment, when a state of the electronic device 101 is an unfolded state (e.g., FIG. 2 or FIGS. 5 to 9), the first coupling portion 310 may be spaced apart from the folding axis A or a central portion of the folding area 233 by a designated second distance d2. For example, the second distance d2 may be greater than a distance from the folding axis A to a boundary between the folding area 233 and the first display area 231. The second distance d2 may have various values according to design changes.

According to an embodiment, as the cover member 400 is coupled to the coupling portions 310 and 310' of the support plate 300, the cover member 400 may be fixed to the support plate 300. Further, the cover member 400 may surround an edge of the flexible display 230 and an edge of the support plate 300. In a state in which the cover member 400 is fixed to the support plate 300, at least a portion of the first protective member 214 may be coupled to a first supporting member (e.g., the first supporting member 212 of FIG. 4). As the first protective member 214 covers at least a portion of the cover member 400, at least a portion of the cover member 400 may be located between the first protective member 214 and the flexible display 230. In a state in which the cover member 400 is fixed to the support plate 300, at least a portion of the second protective member 224 may be coupled to a second supporting member (e.g., the second supporting member 222 of FIG. 4). As the second protective member 224 covers at least a portion of the cover member 400, at least a portion of the cover member 400 may be located between the second protective member 224 and the flexible display 230.

According to an embodiment, the cover member 400 may be configured to be at least partially foldable. For example, the cover member 400 may include an elastically deformable material (e.g., urethane or rubber). When the flexible display 230 is folded, the cover member 400 may be folded with respect to the folding axis A.

According to an embodiment, the cover member 400 may be coupled to at least two points (e.g., the first coupling portion 310 and the second coupling portion 310') of the support plate 300. For example, as the cover member 400 is coupled to two points of the support plate 300, the cover member 400 may be configured to distribute stress applied to the support plate 300 and/or the flexible display 230. For example, as an external impact is applied to the electronic device 101 or as the flexible display 230 is folded or unfolded, tensile stress and/or compressive stress may be applied to the flexible display 230. The tensile stress and/or compressive stress applied to the flexible display 230 may be transmitted to the cover member 400 through the support plate 300.

FIG. 10 is a perspective view illustrating a state in which an edge of a flexible display is covered by a cover member according to an embodiment of the disclosure.

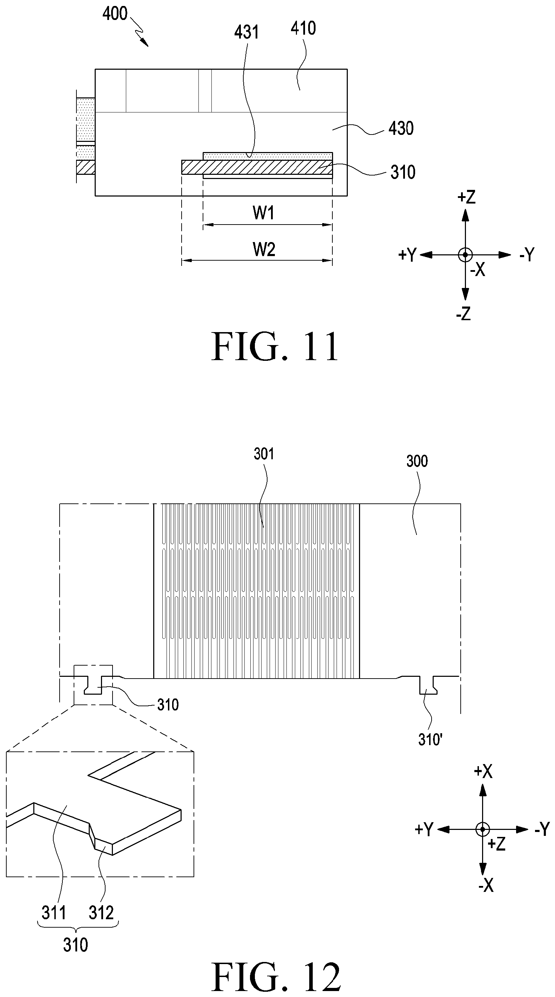

FIG. 11 is a side view illustrating a state in which an edge of a flexible display is covered by a cover member according to an embodiment of the disclosure.

FIG. 12 is a plan view illustrating a support plate according to an embodiment of the disclosure.

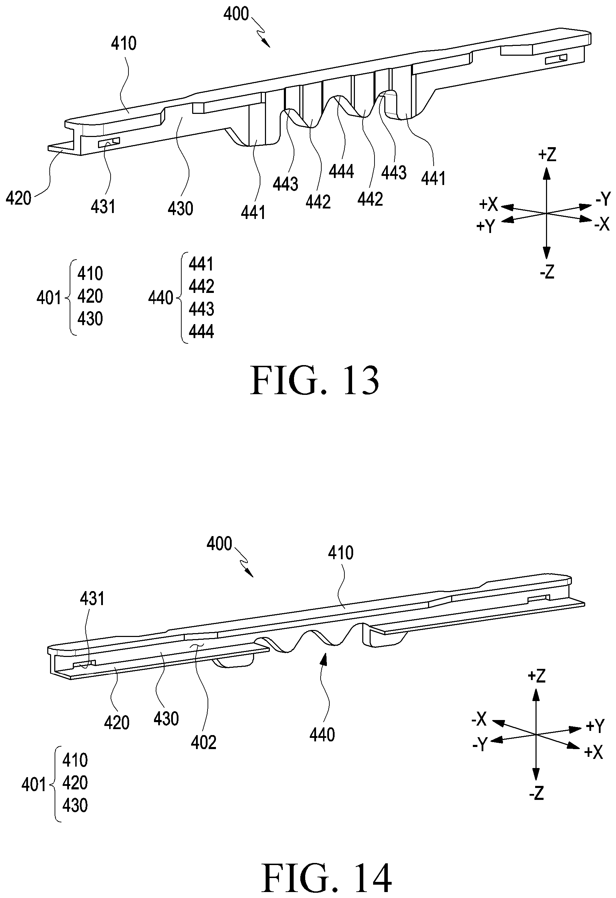

FIG. 13 is a perspective view illustrating a cover member according to an embodiment of the disclosure.

FIG. 14 is a perspective view illustrating a cover member according to an embodiment of the disclosure, viewed from a direction different from FIG. 13.

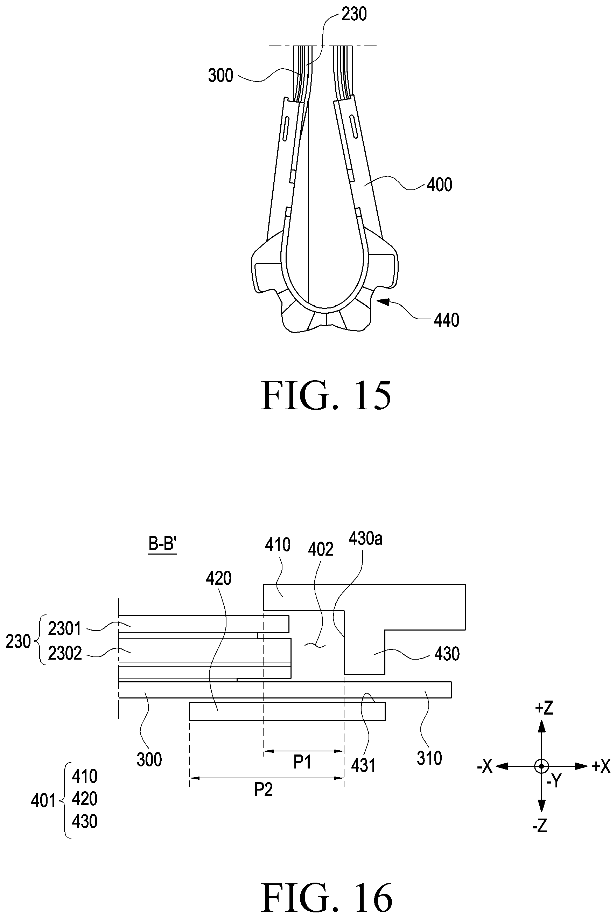

FIG. 15 is a side view illustrating a state in which a flexible display and a cover member are folded according to an embodiment of the disclosure.

FIG. 16 is a cross-sectional view taken along line B-B' of FIG. 8 according to an embodiment of the disclosure.

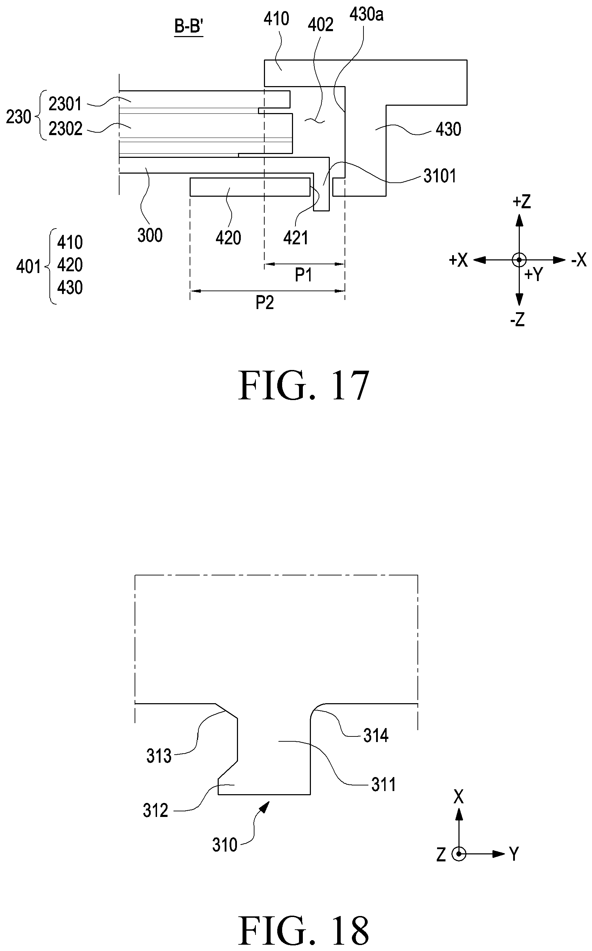

FIG. 17 is a cross-sectional view taken along line B-B' of FIG. 8 according to an embodiment of the disclosure.

The embodiments of FIGS. 10 to 17 may be combined with the embodiments of FIGS. 1 to 7, or the embodiments of FIGS. 15 to 21.

Referring to FIGS. 10 to 17, an electronic device (e.g., the electronic device 101 of FIG. 1 or the electronic device 101 of FIGS. 2 to 7) may include a flexible display 230, a support plate 300, or a cover member 400.

The configuration of the flexible display 230, the support plate 300, or the cover member 400 of FIGS. 10 to 17 may be identical in whole or part to the configuration of the flexible display 230, the support plate 300, or the cover member 400 of FIGS. 5 to 9.

According to an embodiment, at least a portion of an edge of the flexible display 230 may be surrounded or covered by the cover member 400.

According to an embodiment, the cover member 400 may include a body 401 forming an overall appearance of the cover member 400. The body 401 may be integrally formed or may be formed by assembling a plurality of members.

According to an embodiment, the body 401 may include a first body portion 410, a second body portion 420, or a third body portion 430.

According to an embodiment, the first body portion 410 may form at least a portion of an upper surface of the cover member 400 (e.g., a surface facing the +Z direction of FIGS. 10 to 14). The first body portion 410 may cover at least a portion of an upper surface or an outer surface of the flexible display 230. The first body portion 410 may extend from the third body portion 430.

According to an embodiment, the second body portion 420 may form at least a portion of a lower surface of the cover member 400 (e.g., a surface facing the -Z direction of FIGS. 10 to 14). The second body portion 420 may extend from the third body portion 430. The second body portion 420 may be disposed substantially perpendicular to the third body portion 430. The second body portion 420 may be disposed substantially parallel to the first body portion 410. The second body portion 420 may cover at least a portion of a lower surface or an inner surface of the flexible display 230 (e.g., a surface facing the -Z direction of FIGS. 10 to 14). The second body portion 420 may cover at least a portion of an inner surface of the support plate 300.

According to an embodiment, the second body portion 420 may extend longer than the first body portion 410 with respect to the third body portion 430. For example, the second body portion 420 may extend or protrude longer than the first body portion 410 with respect to a direction from the third body portion 430 toward the flexible display 230 (e.g., +X direction of FIG. 13). For example, when viewed in a thickness direction (e.g., Z-axis direction of FIG. 13) of the electronic device 101, the third body portion 430 may have a larger area overlapping the flexible display 230 than the first body portion 410.

According to an embodiment, the third body portion 430 may form at least a portion of a side surface of the cover member 400 (e.g., a surface facing the -X direction of FIGS. 10 to 14). The third body portion 430 may extend from the first body portion 410. The third body portion 430 may be disposed substantially perpendicular to the first body portion 410. The third body portion 430 may cover at least a portion of a side of the flexible display 230. The third body portion 430 may cover at least a portion of a side of the support plate 300.

According to an embodiment, a material of the first body portion 410 may be different from a material of the second body portion 420 and/or a material of the third body portion 430. For example, the first body portion 410 may include a relatively harder material than the second body portion 420 and/or the third body portion 430. For example, the first body portion 410 may include polyethylene terephthalate (PET). The second body portion 420 and/or the third body portion 430 may include urethane or rubber. According to embodiments, the first body portion 410, the second body portion 420, and the third body portion 430 may also be formed of substantially the same material.

According to an embodiment, the support plate 300 may include a first coupling portion 310 (e.g., the first coupling portion 310 of FIGS. 5 to 9) or a second coupling portion 310' (e.g., the second coupling portion 310' of FIGS. 5 to 9). The lattice pattern 301 (e.g., the lattice pattern 301 of FIGS. 5 to 9) of the support plate 300 may be located between the first coupling portion 310 and the second coupling portion 310'.

According to an embodiment, the support plate 300 may be coupled to the body 401 of the cover member 400. For example, the support plate 300 may be coupled to the cover member 400 as the coupling portions 310 and 310' are coupled to the body 401.

According to an embodiment, the cover member 400 may include a coupling area 431. The coupling area 431 may be formed in at least a portion of the body 401. According to an embodiment, the coupling area 431 may be formed through or recessed in at least a portion of the body 401. For example, the coupling area 431 may include a hole formed through at least a portion of the body 401 or a groove recessed in at least a portion of the body 401. For example, the coupling area 431 may be formed as a coupling hole or a coupling groove to which the coupling portions 310 and 310' are coupled in at least a portion of the body 401.

According to an embodiment, the coupling area 431 may be provided in plurality. Some of the plurality of coupling areas 431 may include a coupling hole, and the rest of the plurality of coupling areas 431 may include a coupling groove.

According to an embodiment, a number of the coupling areas 431 may correspond to a number of the coupling portions 310 and 310'. Hereinafter, a case where the first coupling portion 310 and the coupling area 431 are coupled is described as an example, but the description thereof may be equally applied and/or understood for a case where the second coupling portion 310' and the coupling area 431 are coupled.

According to an embodiment, the first coupling portion 310 may be inserted into the coupling area 431. For example, the coupling area 431 and the first coupling portion 310 may be hook-coupled.

According to an embodiment, the first coupling portion 310 may include an extended portion 311 or a protruded portion 312. The extended portion 311 may extend from a side of the support plate 300. The protruded portion 312 may protrude from at least a portion of the extended portion 311. According to the illustrated embodiment, the protruded portion 312 may extend from the extended portion 311 in a direction away from the lattice pattern 301 (e.g., +Y direction of FIG. 12). According to embodiments, the protruded portion 312 may extend from the extended portion 311 in a direction toward the lattice pattern 301 (e.g., -Y direction of FIG. 12). According to embodiments, the protruded portion 312 may also protrude from an upper surface of the extended portion 311 (e.g., a surface facing the +Z direction of FIGS. 10 to 14) or a lower surface of the extended portion 311 (e.g., a surface facing the -Z direction of FIGS. 10 to 14). The second coupling portion 310' may also include configurations identical or similar to the above-described extended portion 311 and/or protruded portion 312.

According to an embodiment, the protruded portion 312 may allow the first coupling portion 310 to be caught and fixed in the coupling area 431. For example, the coupling area 431 may have a first width (e.g., the first width w1 of FIG. 11). As the protruded portion 312 is provided, at least a portion of the first coupling portion 310 may have a second width (e.g., the second width w2 of FIG. 11). The first width w1 may be smaller than the second width w2. At least a portion of the first coupling portion 310 inserted in the coupling area 431 may be caught on at least a portion of the body 401 defining the coupling area 431. Accordingly, in a state in which the support plate 300 and the cover member 400 are coupled, separation of the cover member 400 from the support plate 300 may be limited and/or decreased.

According to an embodiment, as the body 401 includes an elastically deformable material (e.g., urethane or rubber), at least a portion of the body 401 may be elastically deformed and the first coupling portion 310 may be inserted into the coupling area 431.

According to an embodiment, the body 401 of the cover member 400 may be at least partially folded when a state of the flexible display 230 and the support plate 300 is a folded state (e.g., FIG. 15).

According to an embodiment, the cover member 400 may include a variable portion 440. The variable portion 440 may allow the cover member 400 to be easily folded when a state of the electronic device (e.g., the electronic device 101 of FIGS. 2 to 7) is changed to a folded state (e.g., FIG. 2 or FIG. 15).

According to an embodiment, the variable portion 440 may be formed in at least a portion of the body 401. For example, the variable portion 440 may be formed in the third body portion 430. The variable portion 440 may be located corresponding to a folding area (e.g., the folding area 233 of FIGS. 5 to 9) or the lattice pattern 301.

According to an embodiment, the variable portion 440 may include a convex portion 441 or 442 and a concave portion 443 or 444.

According to an embodiment, the convex portion 441 or 442 may include a first convex portion 441 or a second convex portion 442. The first convex portion 441 may protrude or extend downward (e.g., -Z direction of FIG. 13) from the first body portion 410 or the third body portion 430. The second convex portion 442 may protrude or extend downward (e.g., -Z direction of FIG. 13) from the first body portion 410 or the third body portion 430. According to an embodiment, the first convex portion 441 may be provided in plurality. The second convex portion 442 may be provided in plurality. The plurality of second convex portions 442 may be located between the plurality of first convex portions 441.

According to an embodiment, the first convex portion 441 may be larger than the second convex portion 442. For example, an end of the first convex portion 441 (e.g., an end facing the -Z direction of FIG. 13) may be located farther from the first body portion 410 than an end of the second convex portion 442 (e.g., an end facing the -Z direction of FIG. 13).

According to an embodiment, the concave portion 443 or 444 may include a first concave portion 443 or a second concave portion 444. The first concave portion 443 may be located between the first convex portion 441 and the second convex portion 442. For example, the first concave portion 443 may be a recessed portion in the variable portion 440. The first concave portion 443 may be a portion recessed between the first convex portion 441 and the second convex portion 442. The first concave portion 443 may be provided in plurality. The second concave portion 444 may be located between the plurality of second convex portions 442. For example, the second concave portion 444 may be a recessed portion in the variable portion 440. The second concave portion 444 may be a portion recessed between the plurality of second convex portions 442. The second concave portion 444 may be located between the plurality of first concave portions 443. According to the illustrated embodiment, the second concave portion 444 is illustrated as one but, without limitations thereto, may be provided in plurality.

According to an embodiment, the second concave portion 444 may be larger than the first concave portion 443. For example, a lower surface of the second concave portion 444 (e.g., a lower surface facing the +Z direction of FIG. 13) may be located closer to the first body portion 410 than a lower surface of the first concave portion 443 (e.g., an end facing the +Z direction of FIG. 13).

According to an embodiment, the cover member 400, by including the variable portion 440, may provide a structure that is easily foldable. For example, when a state of the electronic device (e.g., the electronic device 101 of FIGS. 2 to 7) is a folded state (e.g., FIG. 3 or FIG. 15), the cover member 400 may be folded together with the flexible display 230 and the support plate 300.

Referring to FIGS. 16 to 17, a state in which the cover member 400 covers at least a portion of an edge of the flexible display 230 is illustrated.

According to an embodiment, the first body portion 410, the second body portion 420, and the third body portion 430 may define a cover groove 402. At least a portion of the edge of the flexible display 230 may be received in the cover groove 402.

According to an embodiment, the flexible display 230 may include a flexible display panel 2302 and a protective layer 2301 configured to protect an outer surface of the flexible display panel 2302. The protective layer 2301 may include glass. The protective layer 2301 may be referred to as a cover window.

According to an embodiment, the first body portion 410 may cover at least a portion of an upper surface of the protective layer 2301 (e.g., a surface facing the +Z direction of FIGS. 16 to 17).

According to an embodiment, the second body portion 420 may cover at least a portion of a lower surface of the support plate 300 (e.g., a surface facing the -Z direction of FIGS. 16 to 17).

According to an embodiment, the third body portion 430 may cover at least a portion of a side of the flexible display panel 2302 (e.g., a surface facing the -X direction of FIGS. 16 to 17) or at least a portion of a side of the protective layer 2301 (e.g., a surface facing the -X direction of FIGS. 16 to 17). The third body portion 430 may cover at least a portion of a side of the support plate 300.

Referring to FIG. 16, at least a portion of the first coupling portion 310 may be located between the first body portion 410 and the second body portion 420. The coupling area 431 may be formed in the third body portion 430. At least a portion of the first coupling portion 310 may be inserted in the coupling area 431.

Referring to FIG. 17, at least a portion of a first coupling portion 3101 (e.g., the first coupling portion 310 of FIG. 16) may be located between the first body portion 410 and the second body portion 420. A coupling area 421 (e.g., the coupling area 421 of FIG. 16) may be formed in the second body portion 420. At least a portion of the first coupling portion 3101 may be inserted in the coupling area 421.

Referring to FIGS. 16 and 17, the third body portion 430 may further include an inner surface 430a facing the flexible display 230. According to an embodiment, with respect to the inner surface 430a of the third body portion 430, a first length P1 by which the first body portion 410 extends toward the flexible display 230 may be smaller than a second length P2 by which the second body portion 420 extends toward the flexible display 230. For example, with respect to the third body portion 430, the second body portion 420 may protrude more toward the flexible display 230 than the first body portion 410.

FIG. 18 is a plan view illustrating a support plate and a coupling portion according to an embodiment of the disclosure.

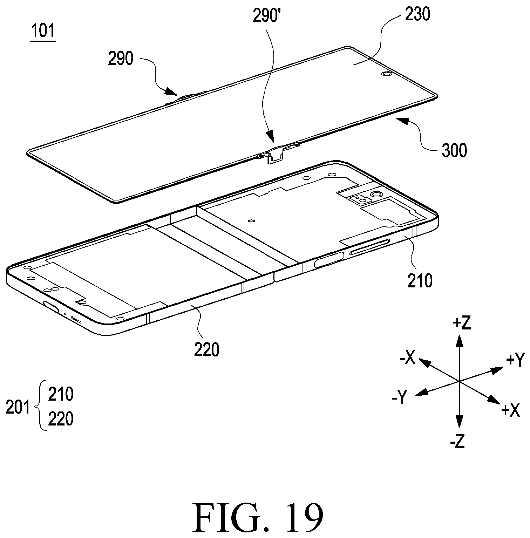

The embodiment of FIG. 18 may be combined with the embodiments of FIGS. 1 to 17 or the embodiments of FIGS. 19 to 21.

Referring to FIG. 18, a support plate (e.g., the support plate 300 of FIGS. 5 to 9) may include a first coupling portion 310 (e.g., the first coupling portion 310 of FIGS. 5 to 9).

The description of the first coupling portion 310 described with reference to FIG. 18 as an example may be equally applied and/or understood for the second coupling portion 310' of FIGS. 5 to 17.

According to an embodiment, the first coupling portion 310 may include an extended portion 311 (e.g., the extended portion 311 of FIG. 12) or a protruded portion 312 (e.g., the protruded portion 312 of FIG. 12).

According to an embodiment, the first coupling portion 310 may include a reinforcement portion 313 or 314. The reinforcement portion 313 or 314 may include a first reinforcement portion 313 or a second reinforcement portion 314.

According to an embodiment, the first reinforcement portion 313 may be formed between the support plate 300 and the extended portion 311. For example, the first reinforcement portion 313 may be configured to enhance rigidity of a portion where the support plate 300 and the extended portion 311 are connected. The first reinforcement portion 313 may include an inclined surface inclined with respect to the extended portion 311, but the disclosure is not limited thereto.

According to an embodiment, the second reinforcement portion 314 may be formed between the support plate 300 and the extended portion 311. For example, the second reinforcement portion 314 may be configured to enhance rigidity of a portion where the support plate 300 and the extended portion 311 are connected. The second reinforcement portion 314 may include a curved surface, but the disclosure is not limited thereto. The second reinforcement portion 314 may face opposite to the first reinforcement portion 313.

FIG. 19 is a perspective view illustrating an electronic device including a flexible display and a blocking assembly according to an embodiment of the disclosure.

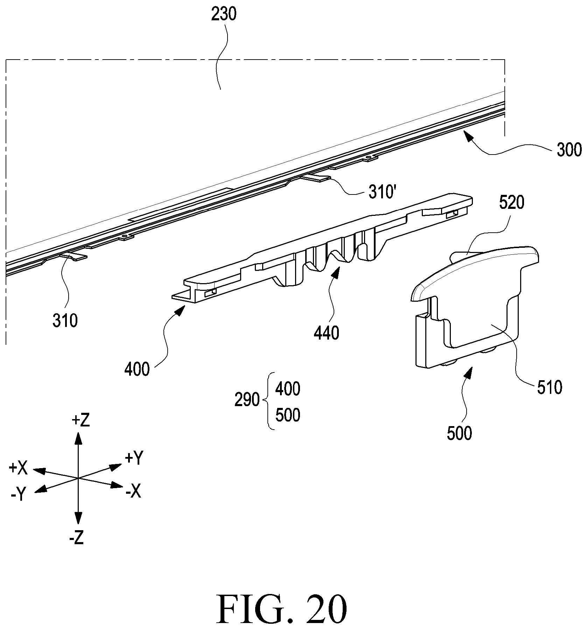

FIG. 20 is an exploded perspective view illustrating a support plate and a blocking assembly according to an embodiment of the disclosure.

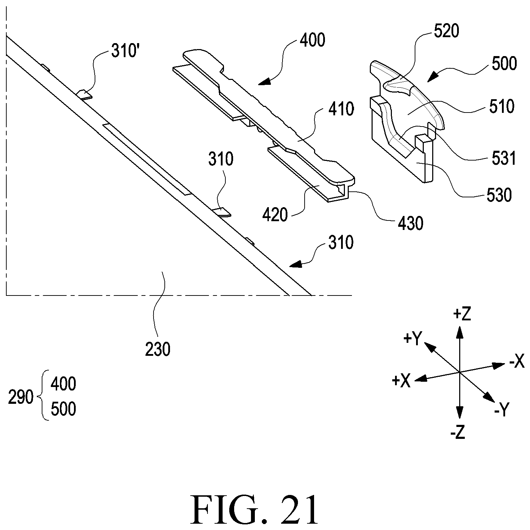

FIG. 21 is an exploded perspective view illustrating a support plate and a blocking assembly according to an embodiment of the disclosure, viewed from a direction different from FIG. 20.

The embodiments of FIGS. 19 to 21 may be combined with the embodiments of FIGS. 1 to 20.

Referring to FIGS. 19 to 21, the electronic device 101 (e.g., the electronic device 101 of FIG. 1 or the electronic device 101 of FIGS. 2 to 5) may include a housing 201, a flexible display 230, or a support plate 300.

The configuration of the housing 201 of FIGS. 19 to 21 may be identical in whole or part to the configuration of the housing 201 of FIGS. 2 to 4. The configuration of the flexible display 230 or the support plate 300 of FIGS. 19 to 21 may be identical in whole or part to the configuration of the flexible display 230 or the support plate 300 of FIGS. 5 to 9.

According to an embodiment, the flexible display 230 may be disposed over the housing 201. The support plate 300 may be disposed between the flexible display 230 and the housing 201. The support plate 300 may be configured to support the flexible display 230.

According to an embodiment, the housing 201 may include a first housing 210 (e.g., the first housing 210 of FIG. 4) or a second housing 220 (e.g., the second housing 220 of FIG. 4).

According to an embodiment, the electronic device 101 may include a blocking assembly 290 or 290'. The blocking assembly 290 may be disposed to cover at least a portion of an edge of the flexible display 230. The blocking assembly 290 may limit and/or reduce external foreign objects from entering inside the housing 201 through a gap between the edge of the flexible display 230 and the housing 201.

According to an embodiment, the blocking assembly 290 or 290' may be provided as a pair respectively disposed on both side edges of the flexible display 230. For example, the blocking assembly 290 may include a first blocking assembly 290 covering at least a portion of one side edge of the flexible display 230 (e.g., an edge facing the -X direction of FIG. 19) or a second blocking assembly 290' covering at least a portion of the other side edge of the flexible display 230 (e.g., an edge facing the +X direction of FIG. 19). Hereinafter, for convenience of description, the first blocking assembly 290 is described as an example, but the description thereof may be equally applied and/or understood for the second blocking assembly 290'.

According to an embodiment, the first blocking assembly 290 may include a cover member 400 (e.g., the cover member 400 of FIGS. 5 to 19) or a cap member 500.

According to an embodiment, the cover member 400 may be coupled to the coupling portions 310 and 310' (e.g., the coupling portions 310 and 310' of FIGS. 5 to 9) of the support plate 300.

According to an embodiment, the cap member 500 may be coupled to the cover member 400. For example, the cap member 500 may be disposed to surround at least a portion of the cover member 400.

According to an embodiment, the cap member 500 may include a first cap portion 510, a second cap portion 520, or a third cap portion 530. The first cap portion 510 may cover at least a portion of an outer surface of the third body portion 430 (e.g., the third body portion 430 of FIG. 13) of the cover member 400 (e.g., a surface facing the -X direction of FIGS. 20 to 21). For example, the first cap portion 510 may cover at least a portion of the variable portion 440 (e.g., the variable portion 440 of FIG. 13). The second cap portion 520 may protrude from an upper end of the first cap portion 510 toward the cover member 400. The second cap portion 520 may cover at least a portion of an upper surface of the first body portion 410 (e.g., the first body portion 410 of FIG. 13) (e.g., a surface facing the +Z direction of FIGS. 20 to 21). The second cap portion 520 may be located corresponding to a folding axis (e.g., the folding axis A of FIGS. 5 to 9). The second cap portion 520 may be configured to protect the upper surface of the first body portion 410 from an external impact. The third cap portion 530 may be coupled to the first cap portion 510. At least a portion of the third cap portion 530 may cover at least a portion of a lower surface of the second body portion 420 (e.g., the second body portion 420 of FIG. 13) (e.g., a surface facing the -Z direction of FIGS. 20 to 21). The third cap portion 530 may include an accommodation groove 531. The accommodation groove 531 may be recessed from at least a portion of the third cap portion 530. The accommodation groove 531 may be configured to receive at least a portion of the variable portion 440 in a folded state when a state of the cover member 400 is a folded state.

A foldable electronic device may include a flexible display configured to be at least partially folded or unfolded in order to provide a large-area display screen.

An electronic device including a flexible display may include components such as a hinge disposed at a position corresponding to a portion where the flexible display is folded. Due to a space occupied by such components, a space for components to be disposed for distributing an impact applied to the flexible display may be insufficient. Further, due to stress acting when the flexible display is folded or unfolded, shearing deformation may occur in the flexible display having a structure in which a plurality of components are stacked.

According to an embodiment of the disclosure, a cover member configured to distribute stress applied to a flexible display and an electronic device including the same may be provided.

According to an embodiment of the disclosure, a cover member capable of limiting and/or reducing external foreign objects from entering inside an electronic device and an electronic device including the same may be provided.

However, the problems to be solved by the disclosure are not limited to the above-mentioned problems, and may be variously extended without departing from the spirit and scope of the disclosure.

According to an embodiment of the disclosure, an electronic device including a cover member configured to alleviate compressive stress and/or tensile stress applied to a flexible display may be provided.

Effects obtainable from the disclosure are not limited to the above-mentioned effects, and other effects not mentioned is clearly understood by those of ordinary skill in the art to which the disclosure pertains from the following description.

According to an embodiment of the disclosure, an electronic device 101 may include a housing 201, a flexible display 230, a support plate 300, or a cover member 400. The housing 201 may include a first housing 210 or a second housing 220. The second housing 220 may be disposed to be rotatable with respect to the first housing 210. The flexible display 230 may be disposed over the housing 201. The support plate 300 may be disposed between the housing 201 and the flexible display 230. The support plate 300 may be configured to support the flexible display 230. The cover member 400 may cover at least a portion of an edge of the flexible display 230. The cover member 400 may be coupled to the support plate 300.

According to an embodiment, the cover member 400 may include a body 401 or a coupling area 431. The body 401 may surround the flexible display 230 and the support plate 300. The coupling area 431 may be formed in at least a portion of the body 401. The support plate 300 may include a coupling portion 310 or 310'. The coupling portion 310 or 310' may protrude from at least a portion of the support plate 300. The coupling portion 310 or 310' may be inserted in the coupling area 431.

According to an embodiment, a width of at least a portion of the coupling portion 310 or 310' may be greater than a width of the coupling area 431.

According to an embodiment, the body 401 may include a cover groove 402. The cover groove 402 may receive the flexible display 230 and the support plate 300.

According to an embodiment, the body 401 may include a first body portion 410, a second body portion 420, or a third body portion 430. The first body portion 410 may cover the outer surface of the flexible display 230. The second body portion 420 may cover the inner surface of the flexible display 230. The third body portion 430 may be connected to the first body portion 410 and the second body portion 420.

According to an embodiment, the third body portion 430 may cover at least a portion of a side of the flexible display 230.

According to an embodiment, the coupling area 431 may be formed in the third body portion 430.

According to an embodiment, the coupling area 421 may be formed in the second body portion 420.

According to an embodiment, the cover member 400 may include a variable portion 440. The variable portion 440 may be formed in the third body portion 430. The variable portion 440 may include a plurality of convex portions 441 and 442 or a plurality of concave portions 443 and 444. The plurality of concave portions 443 and 444 may be disposed to be concave with respect to the plurality of convex portions 441 and 442.

According to an embodiment, the cover member 400 may include an elastically deformable material.

According to an embodiment, the first body portion 410 may include a material which is harder than a material of the third body portion 430.

According to an embodiment, the coupling portion 310 or 310' may include an extended portion 311 or a protruded portion 312. The extended portion 311 may extend from the support plate 300. The protruded portion 312 may protrude from the extended portion 311.

According to an embodiment, the coupling portion 310 or 310' may include a first coupling portion 310 or a second coupling portion 310'. The second coupling portion 310' may be spaced apart from the first coupling portion 310. The support plate 300 may include a lattice pattern 301. The lattice pattern 301 may include a plurality of openings formed through the support plate 300.

According to an embodiment, the lattice pattern 301 may be located between the first coupling portion 310 and the second coupling portion 310'.

According to an embodiment, the first coupling portion 310 may be spaced apart from the second coupling portion 310' by a designated distance. The designated distance may be greater than a width of the lattice pattern 301.

According to an embodiment of the disclosure, an electronic device 101 may include a housing 201, a flexible display 230, a support plate 300, or a cover member 400. The housing 201 may include a first housing 210 or a second housing 220. The second housing 220 may be disposed to be rotatable with respect to the first housing 210. The flexible display 230 may be disposed over the housing 201. The support plate 300 may be disposed between the housing 201 and the flexible display 230. The support plate 300 may be configured to support the flexible display 230. The support plate 300 may include a lattice pattern 301. The lattice pattern 301 may include a plurality of openings. The cover member 400 may cover at least a portion of an edge of the flexible display 230. The cover member 400 may be located corresponding to the lattice pattern 301.

According to an embodiment, the cover member 400 may include a first body portion 410, a second body portion 420, or a third body portion 430. The first body portion 410 may cover the outer surface of the flexible display 230. The second body portion 420 may cover the inner surface of the flexible display 230. The third body portion 430 may be connected to the first body portion 410 and the second body portion 420.

According to an embodiment, the electronic device 101 may further include a cap member 500. The cap member 500 may be coupled to the cover member 400.

According to an embodiment, the cap member 500 may include a first cap portion 510 or a second cap portion 520. The first cap portion 510 may be disposed on the third body portion 430. The second cap portion 520 may protrude from the first cap portion 510. The second cap portion 520 may be disposed on the first body portion 410.

According to an embodiment, the cover member 400 may be configured to be at least partially foldable.

While the disclosure has been shown and described with reference to exemplary embodiments thereof, it will be apparent to those of ordinary skill in the art that various changes in form and detail may be made thereto without departing from the spirit and scope of the present invention as defined by the following claims.

## Claims

1. An electronic device (101) comprising:
a housing (201) including a first housing (210) and a second housing (220) disposed to be rotatable with respect to the first housing (210);
a flexible display (230) disposed over the housing (201);
a support plate (300) disposed between the housing (201) and the flexible display (230) and configured to support the flexible display (230); and
a cover member (400) covering at least a portion of an edge of the flexible display (230) and coupled to the support plate (300).

2. The electronic device of claim 1, wherein the cover member (400) includes a body (401) surrounding the flexible display (230) and the support plate (300) and a coupling area (431) formed in at least a portion of the body (401), and
wherein the support plate (300) includes a coupling portion (310, 310') protruded from at least a portion of the support plate (300) and inserted in the coupling area (431).

3. The electronic device of claim 1 or 2, wherein a width of at least a portion of the coupling portion (310, 310') is greater than a width of the coupling area (431).

4. The electronic device of any one of claims 1 to 3, wherein the body (401) includes a cover groove (402) accommodating the flexible display (230) and the support plate (300).

5. The electronic device of any one of claims 1 to 4, wherein the body (401) includes:
a first body portion (410) covering an outer surface of the flexible display (230);
a second body portion (420) covering an inner surface of the flexible display (230); and
a third body portion (430) connected to the first body portion (410) and the second body portion (420).

6. The electronic device of any one of claims 1 to 5, wherein the third body portion (430) covers at least part of a side of the flexible display (230).

7. The electronic device of any one of claims 1 to 6, wherein the coupling area (431) is formed in the third body portion (430).

8. The electronic device of any one of claims 1 to 7, wherein the coupling area (421) is formed in the second body portion (420).

9. The electronic device of any one of claims 1 to 8, wherein the cover member (400) includes a variable portion (440) formed in the third body portion (430), and
wherein the variable portion (440) includes:
a plurality of convex portions (441, 442); and
a plurality of concave portions (443, 444) disposed to be concave with respect to the plurality of convex portions (441, 442).

10. The electronic device of any one of claims 1 to 9, wherein the cover member (400) includes an elastically deformable material.

11. The electronic device of any one of claims 1 to 10, wherein the first body portion (410) includes a material which is harder than a material of the third body portion (430).

12. The electronic device of any one of claims 1 to 11, wherein the coupling portion (310, 310') includes:
an extended portion (311) extended from the support plate (300); and
a protruded portion (312) protruded from the extended portion (311).

13. The electronic device of any one of claims 1 to 12, wherein the coupling portion (310, 310') includes:
a first coupling portion (310); and
a second coupling portion (310') spaced apart from the first coupling portion (310),
wherein the support plate (300) includes a lattice pattern (301) including a plurality of openings formed through the support plate (300).

14. The electronic device of any one of claims 1 to 13, wherein the lattice pattern (301) is located between the first coupling portion (310) and the second coupling portion (310').

15. The electronic device of any one of claims 1 to 14, wherein the first coupling portion (310) is spaced apart from the second coupling portion (310') by a specified distance, and
wherein the specified distance is greater than a width of the lattice pattern (301).
